# EUROPEAN PATENT APPLICATION

(11) **EP 4 718 120 A1**
(43) Date of publication of application: **01.04.2026**
(21) Application number: 24810229.5
(22) Date of filing: 10.05.2024
(51) Int. Cl.: G01S 17/931, G01S 17/08, G01S 7/48

(54) **DATA COMPRESSION METHOD AND APPARATUS, AND DEVICE AND MEDIUM**

(30) Priority: 22.05.2023 CN 202310596477
(71) Applicant: Shanghai Cambricon Information Technology Co., Ltd, Shanghai 201306 (CN)
(72) Inventor: YIN, Wanchun, Shanghai 201306 (CN)
(74) Representative: Huang, Liwei
(86) International application number: PCT/CN2024/092454
(87) International publication number: WO 2024/239982

(57) **Abstract**

The present disclosure provides a data compression device including an obtaining unit, a processing unit and a transmitting unit. Based on the technical solution provided by this disclosure, the amount of data transmitted is greatly reduced, thereby improving transmission efficiency.

## Description

The present disclosure claims priority to Chinese Patent Application No. 202310596477X with the title of "Data Compression Method, Apparatus, Device and Medium" filed on May 22, 2023, the entire contents of which are incorporated herein by reference.

### TECHNICAL FIELD

The present disclosure relates to the field of artificial intelligence, and in particular to a data compression method, apparatus, device, and medium.

### BACKGROUND

In an autonomous driving system, a lidar scanner scans the surrounding environment, providing important data for the perception of the autonomous driving system, and transmits the scanned data to the control end of the autonomous driving system. The control end adjusts the driving direction and speed of the vehicle based on the data scanned by the lidar scanner.

Currently, the data obtained by the lidar scanners is similar to image data. The data volume is large and the transmission efficiency is low, which makes it difficult for the autonomous driving system to adjust the direction and speed of the vehicle in a timely manner.

### SUMMARY

The present disclosure provides a data compression method, apparatus, device and medium, which compress and transmit the residual matrix of the lidar scanner and the distance matrix between the surrounding environment and the lidar scanner in an autonomous driving system. Since the transmitted data is matrix data, the amount of the transmitted data is greatly reduced, thereby improving transmission efficiency.

A first aspect of the present disclosure provides a data compression method, including:
obtaining a pose matrix at a current moment and a distance matrix at the current moment, where the pose matrix represents a rotation angle and position of a lidar scanner, and the distance matrix represents a distance value between a spatial point scanned by the lidar scanner and the lidar scanner;
retrieving a pose matrix at a previous moment from historical pose matrices stored at a decoding end, and computing a difference value between the pose matrix at the current moment and the pose matrix at the previous moment to obtain a residual matrix; and
transmitting the residual matrix and the distance matrix at the current moment to the decoding end after encoding the residual matrix and the distance matrix at the current moment, so that the decoding end obtains the pose matrix at the current moment based on the residual matrix and the pose matrix at the previous moment and stores the pose matrix at the current moment and the distance matrix at the current moment.

A second aspect of the present disclosure provides a data compression apparatus, including:
an obtaining unit configured to obtain a pose matrix at a current moment and a distance matrix at the current moment, where the pose matrix represents a rotation angle and position of a lidar scanner, and the distance matrix represents a distance value between a spatial point scanned by the lidar scanner and the lidar scanner;
a processing unit configured to retrieve a pose matrix at a previous moment from historical pose matrices stored at a decoding end and compute a difference value between the pose matrix at the current moment and the pose matrix at the previous moment to obtain a residual matrix; and
a transmitting unit configured to transmit the residual matrix and the distance matrix at the current moment to the decoding end after encoding the residual matrix and the distance matrix at the current moment, so that the decoding end obtains the pose matrix at the current moment based on the residual matrix and the pose matrix at the previous moment and stores the pose matrix at the current moment and the distance matrix at the current moment.

A third aspect of the present disclosure provides an electronic device, including: a processor, and a memory communicatively connected to the processor, where
the memory stores computer execution instructions; and
the processor executes the computer execution instructions stored by the memory to implement the method as described in any one of the preceding items.

A fourth aspect of the present disclosure provides a computer-readable storage medium, where the computer-readable storage medium stores computer execution instructions, which, when executed by a processor, implement the method as described in any one of the preceding items.

According to the data compression method, apparatus, device and medium provided by the present disclosure, the pose matrix at the current moment and the distance matrix at the current moment are first obtained, where the pose matrix represents the rotation angle and position of the lidar scanner, and the distance matrix represents the distance value between the spatial point scanned by the lidar scanner and the lidar scanner; the pose matrix at the previous moment is retrieved from the historical pose matrices stored at the decoding end, and the difference value between the pose matrix at the current moment and the pose matrix at the previous moment is computed to obtain the residual matrix; the residual matrix and the distance matrix at the current moment are transmitted to the decoding end after being encoded, so that the decoding end obtains the pose matrix at the current moment based on the residual matrix and the pose matrix at the previous moment and stores the pose matrix at the current moment and the distance matrix at the current moment. The present disclosure is based on compressing and transmitting the residual matrix of the lidar scanner in the autonomous driving system and the distance matrix between the surrounding environment and the lidar scanner. Since the transmitted data is matrix data, the amount of the transmitted data is greatly reduced, thereby improving transmission efficiency.

### BRIEF DESCRIPTION OF DRAWINGS

The accompanied drawings herein are incorporated into the specification and constitute a part of the specification, illustrate embodiments that conform to the present disclosure, and are used together with the specification to explain principles of the embodiments of the present disclosure.
FIG. 1 is a schematic diagram of an application scenario of an example of the present disclosure.
FIG. 2 is a flowchart of a data compression method provided in the embodiment 1 of the present disclosure.
FIG. 3 is a flowchart of a data compression method provided in the embodiment 1 of the present disclosure.
FIG. 4 is a flowchart of a data compression method provided in the embodiment 1 of the present disclosure.
FIG. 5 is a flowchart of a data compression method provided in the embodiment 1 of the present disclosure.
FIG. 6 is a flowchart of a data compression method provided in the embodiment 1 of the present disclosure.
FIG. 7 is a flowchart of a data compression method provided in the embodiment 1 of the present disclosure.
FIG. 8 is a schematic diagram of a structure of a data compression apparatus provided in the embodiment 2 of the present disclosure.
FIG. 9 is a flowchart of a data compression system provided in the embodiment 3 of the present disclosure.
FIG. 10 is a schematic diagram of a structure of an electronic device provided in the embodiment 4 of the present disclosure.

The above drawings have shown explicit embodiments of the present disclosure, which will be described in more detail below. These drawings and textual descriptions are not intended to limit the scope of the present disclosure in any way, but rather to explain the concept of the present disclosure to those skilled in the art by referring to specific embodiments.

### DETAILED DESCRIPTION

The exemplary embodiments will be described in detail, and examples thereof are shown in the accompanied drawings. Unless otherwise indicated, identical numbers in different drawings indicate identical or similar elements. The implementations described in the following exemplary embodiments do not represent all implementations consistent with the present disclosure. Rather, they are merely examples of apparatus and methods consistent with some aspects of the disclosure as recited in the appended claims.

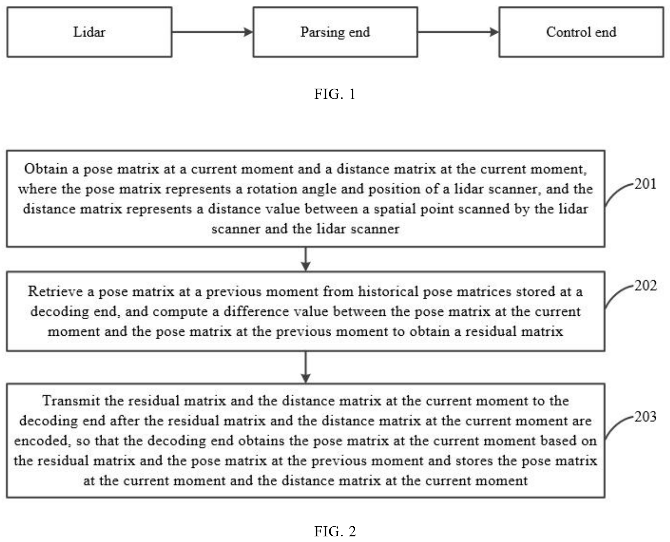

FIG. 1 is a schematic diagram of an application scenario of an example of the present disclosure. On a vehicle of an autonomous driving system, a lidar scanner is used to scan the surrounding environment and transmit the obtained data to a parsing end. The parsing end is used to parse and analyze the data scanned by the lidar scanner, and a control end adjusts the direction and speed of the vehicle according to the data from the parsing end. However, the data currently scanned by the lidar scanner is similar to image data, with a large amount of data and low transmission efficiency, which makes it difficult for the autonomous driving system to adjust the direction and speed of the vehicle in a timely manner.

The present disclosure is based on compressing and transmitting the residual matrix of the lidar scanner and the distance matrix between the surrounding environment and the lidar scanner in the autonomous driving system. Since the transmitted data is matrix data, the amount of the transmitted data is greatly reduced, thereby improving the transmission efficiency.

It should be noted that the brief description of terms in the present disclosure is only for facilitating the understanding of the embodiments described below, and is not intended to limit the embodiments of the present disclosure. Unless otherwise stated, these terms should be understood according to their ordinary and customary meanings.

The technical solutions of the present disclosure are described in detail below with reference to specific embodiments. The following specific embodiments may be combined with each other, and the same or similar concepts or processes may not be described in detail in some embodiments. In the description of the present disclosure, unless otherwise clearly defined and defined, each term should be understood broadly in the art. The embodiments of the present disclosure will be described below with reference to the accompanying drawings.

### Embodiment 1

FIG. 2 is a flowchart of a data compression method provided in the embodiment 1 of the present disclosure. As shown in FIG. 2, the method includes:
in step 201, obtaining a pose matrix at a current moment and a distance matrix at the current moment, where the pose matrix represents a rotation angle and position of a lidar scanner, and the distance matrix represents a distance value between a spatial point scanned by the lidar scanner and the lidar scanner;
in step 202, retrieving a pose matrix at a previous moment from historical pose matrices stored at a decoding end and computing a difference value between the pose matrix at the current moment and the pose matrix at the previous moment to obtain a residual matrix; and
in step 203, transmitting the residual matrix and the distance matrix at the current moment to the decoding end after the residual matrix and the distance matrix at the current moment are encoded, so that the decoding end obtains the pose matrix at the current moment based on the residual matrix and the pose matrix at the previous moment and stores the pose matrix at the current moment and the distance matrix at the current moment.

The executor of this embodiment is a data compression apparatus, which may be implemented through a computer program, such as application software, etc.; or, it may also be implemented as a medium storing relevant computer programs, such as a USB flash drive, a cloud disk, etc.; or, it may also be implemented through a physical device integrated or installed with relevant computer programs, such as a chip, etc.

In combination with a scenario example, a vehicle using an autonomous driving system relies on a lidar scanner to obtain relevant data about the surrounding environment during operation. During the operation of the vehicle, the relative position of the vehicle and the ground is constantly changing, so the relative position between the lidar scanner and the ground is also constantly changing. Specifically, a pose matrix may be selected to represent the relative position between the lidar scanner and the ground and the rotation angle of the lidar scanner. The lidar scanner scans environmental information in the direction directly in front of the lidar scanner. Specifically, the environmental information in the direction directly in front of the lidar scanner may be recorded in the form of a distance matrix. The distance matrix includes the distance between each point of all objects in the space in the direction directly in front of the lidar scanner and the lidar scanner.

When a vehicle is driving, the speed and direction of the vehicle at the next moment is judged by first obtaining the pose matrix and distance matrix of the lidar scanner at the current moment, and then retrieving the pose matrix of the lidar scanner at the previous moment from the decoding end. According to the pose matrices of the lidar scanner at the current moment and the previous moment, the residual matrix of the lidar scanner may be obtained. Specifically, the pose matrix of the lidar scanner at the current moment may be subtracted from the pose matrix of the lidar scanner at the previous moment to obtain the residual matrix of the lidar scanner. The residual matrix represents the changes of the lidar scanner, including changes in position and rotation angle. Then the residual matrix and distance matrix at the current moment are encoded and then transmitted to the decoding end, and the decoding end may obtain the residual matrix and distance matrix, and the residual matrix is added to the pose matrix at the previous moment to obtain the pose matrix at the current moment, and the pose matrix and distance matrix of the lidar scanner at the current moment are stored. At the same time, the pose matrix and distance matrix of the lidar scanner at the current moment are transmitted to the control end, so that the control end may make timely adjustments to the driving speed and direction of the vehicle according to the pose matrix and the distance matrix at the current moment.

According to the data compression method provided by the embodiment of the present disclosure, the pose matrix at the current moment and the distance matrix at the current moment are first obtained, where the pose matrix represents the rotation angle and position of the lidar scanner, and the distance matrix represents the distance value between the spatial point scanned by the lidar scanner and the lidar scanner; the pose matrix at the previous moment is retrieved from the historical pose matrices stored at the decoding end, and the difference value between the pose matrix at the current moment and the pose matrix at the previous moment is computed to obtain the residual matrix; and the residual matrix and the distance matrix at the current moment are transmitted to the decoding end after being encoded, so that the decoding end obtains the pose matrix at the current moment based on the residual matrix and the pose matrix at the previous moment and stores the pose matrix at the current moment and the distance matrix at the current moment. Based on the method provided by the embodiment of the present disclosure, the residual matrix of the lidar scanner and the distance matrix between the surrounding environment and the lidar scanner in the autonomous driving system are compressed and transmitted. Since the transmitted data is matrix data, the amount of the transmitted data is greatly reduced, thereby improving the transmission efficiency.

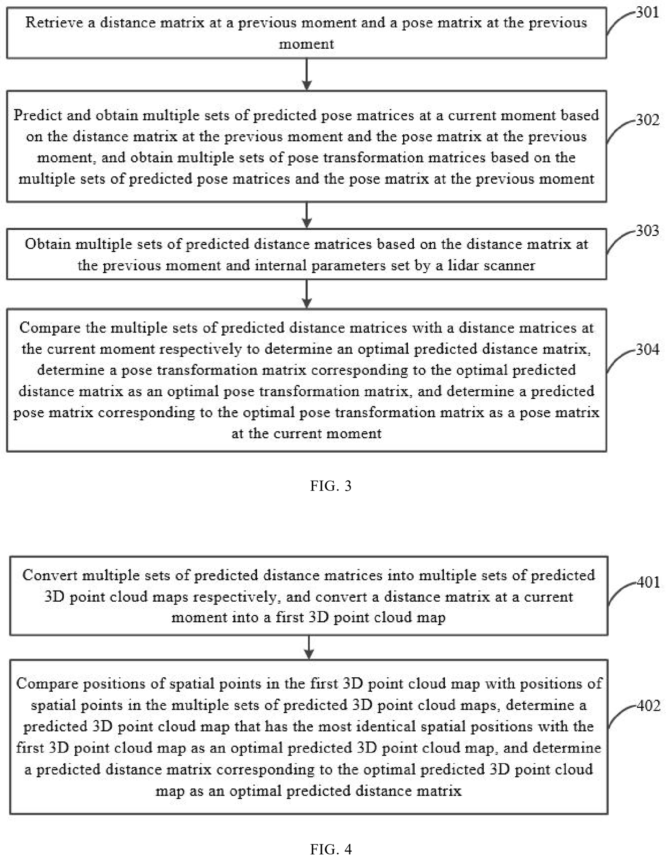

Alternatively, FIG. 3 is a flowchart of a data compression method provided in the embodiment 1 of the present disclosure. As shown in FIG. 3, in step 201, obtaining the pose matrix at the current moment includes:
in step 301, retrieving a distance matrix at a previous moment and a pose matrix at the previous moment;
in step 302, based on the distance matrix at the previous moment and the pose matrix at the previous moment, predicting and obtaining multiple sets of predicted pose matrices at the current moment, and obtaining multiple sets of pose transformation matrices based on the multiple sets of predicted pose matrices and the pose matrix at the previous moment;
in step 303, obtaining multiple sets of predicted distance matrices based on the distance matrix at the previous moment and internal parameters set by the lidar scanner; and
in step 304, comparing the multiple sets of predicted distance matrices with the distance matrices at the current moment respectively to determine an optimal predicted distance matrix, determining a pose transformation matrix corresponding to the optimal predicted distance matrix as an optimal pose transformation matrix, and determining a predicted pose matrix corresponding to the optimal pose transformation matrix as the pose matrix at the current moment.

In combination with a scenario example, when the vehicle is driving, the pose matrix of the lidar scanner may first make multiple sets of predictions based on the distance matrix at the previous moment and the pose matrix at the previous moment to obtain multiple sets of predicted pose matrices at the current moment. Each set of predicted pose matrices respectively represents the position and rotation angle that the lidar scanner may have at the current moment, and then the pose matrix at the previous moment is subtracted from the multiple sets of predicted pose matrices to obtain multiple sets of predicted pose transformation matrices. The distance matrix at the previous moment is retrieved from the decoding end, and the internal parameters set by the lidar scanner at the previous moment may be obtained based on the pose matrix at the previous moment. The internal parameters refer to the internal parameters of the lidar scanner. The spatial coordinates of objects in the surrounding environment in a spatial coordinate system at the previous moment may be computed based on the internal parameters set by the lidar scanner and the distance matrix at the previous moment, and then the spatial coordinates of the objects in the surrounding environment in the spatial coordinate system at the previous moment are multiplied by the multiple sets of pose transformation matrices respectively to obtain multiple sets of spatial coordinates of objects in the surrounding environment in the spatial coordinate system at the current moment, and then multiple sets of predicted distance matrices are obtained through the internal parameters of the lidar scanner. The predicted distance matrix is a prediction of the distance matrix at the current moment, so the distance matrix actually collected by the lidar scanner at the current moment is compared with the predicted distance matrix to obtain a predicted distance matrix with the most accurate prediction, and the predicted distance matrix with the most accurate prediction is used as the optimal predicted distance matrix. Since there is a one-to-one correspondence between multiple sets of predicted distance matrices and multiple sets of predicted pose transformation matrices, the optimal pose transformation matrix may be determined based on the optimal predicted distance matrix. Similarly, the predicted pose transformation matrix has a one-to-one correspondence with multiple sets of predicted pose matrices at the current moment, so the optimal predicted pose matrix may be determined based on the optimal pose transformation matrix, and the optimal predicted pose matrix is used as the pose matrix at the current moment. This example predicts multiple sets of pose matrices at the current moment to obtain multiple sets of pose transformation matrices and multiple sets of predicted distance matrices. The pose matrix at the current moment is determined by selecting the optimal predicted distance matrix.

Alternatively, FIG. 4 is a flowchart of a data compression method provided in the embodiment 1 of the present disclosure. As shown in FIG. 4, in step 304, comparing the multiple sets of predicted distance matrices with the distance matrices at the current moment respectively to determine the optimal predicted distance matrix includes:
in step 401, converting the multiple sets of predicted distance matrices into multiple sets of predicted 3D point cloud maps respectively, and converting the distance matrix at the current moment into a first 3D point cloud map; and
in step 402, comparing positions of spatial points in the first 3D point cloud map with positions of spatial points in the multiple sets of predicted 3D point cloud maps, determining a predicted 3D point cloud map that has the most identical spatial positions with the first 3D point cloud map as an optimal predicted 3D point cloud map, and determining a predicted distance matrix corresponding to the optimal predicted 3D point cloud map as the optimal predicted distance matrix.

In combination with a scenario example, after multiple sets of predicted distance matrices are obtained, multiple sets of predicted 3D point cloud maps may be obtained by converting distance values recorded in each set of predicted distance matrices into corresponding 3D point cloud maps. At the same time, a distance matrix corresponding to a current moment is converted into a first 3D point cloud map. The information in the 3D point cloud map mainly includes spatial position coordinates of each point scanned by the lidar scanner at the current moment. Then, position coordinates represented in each set of predicted 3D point cloud maps are compared with position coordinates represented by the first 3D point cloud map, and the number of identical position coordinates between each set of predicted 3D point cloud maps and the first 3D point cloud map is observed. The predicted 3D point cloud map that has the most identical position coordinates with the first 3D point cloud map is determined as the optimal predicted 3D point cloud map. Then, the predicted distance matrix corresponding to the optimal predicted 3D point cloud map is determined as the optimal predicted distance matrix, and a pose transformation matrix corresponding to the optimal predicted distance matrix is determined as an optimal pose transformation matrix. Then, a predicted pose matrix corresponding to the optimal pose transformation matrix is determined as an optimal predicted pose matrix, and the optimal predicted pose matrix is determined as the corresponding pose matrix at the current moment.

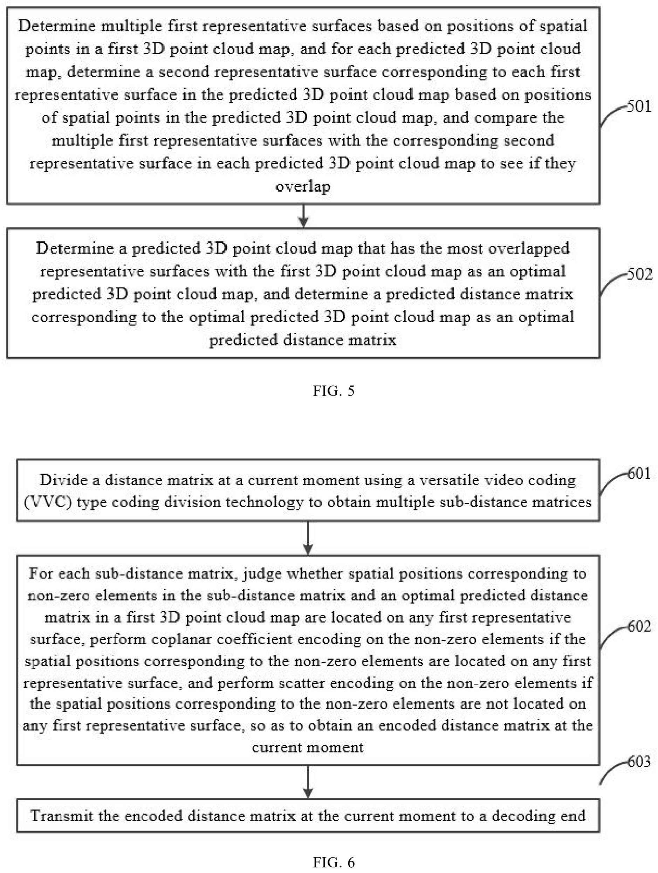

Alternatively, FIG. 5 is a flowchart of a data compression method provided in the embodiment 1 of the present disclosure. As shown in FIG. 5, the method further includes:
in step 501, determining multiple first representative surfaces based on the positions of the spatial points in the first 3D point cloud map, and for each predicted 3D point cloud map, determining a second representative surface corresponding to each first representative surface in the predicted 3D point cloud map based on positions of spatial points in the predicted 3D point cloud map, and comparing the multiple first representative surfaces with the corresponding second representative surface in each predicted 3D point cloud map to see if they overlap; and
in step 502, determining a predicted 3D point cloud map that has the most overlapped representative surfaces with the first 3D point cloud map as the optimal predicted 3D point cloud map and determining a predicted distance matrix corresponding to the optimal predicted 3D point cloud map as the optimal predicted distance matrix.

In combination with a scenario example, determining the optimal predicted 3D point cloud map from the multiple sets of predicted 3D point cloud maps may also be based on observing the number of representative surfaces with the same direction between the multiple sets of predicted 3D point cloud maps and the first 3D point cloud map, and a predicted 3D point cloud map with the most representative surfaces with the same direction as the first 3D point cloud map is determined as the optimal predicted 3D point cloud map. Specifically, first, multiple first representative surfaces are determined based on spatial position coordinates of each point in the first 3D point cloud map, and then on each set of predicted 3D point cloud maps, a second representative surface corresponding to each first representative surface is determined, and the direction between each first representative surface and its corresponding second representative surface is determined. If the directions are the same, it is determined that each first representative surface overlaps with its corresponding second representative surface. After the representative surfaces of the first 3D point cloud map are compared with those of each set of predicted 3D point cloud maps in turn, the predicted 3D point cloud map having the most representative surfaces in the same direction as those of the first 3D point cloud map is determined as the optimal predicted 3D point cloud map. Then, the predicted distance matrix corresponding to the optimal predicted 3D point cloud map is determined as the optimal predicted distance matrix, and a pose transformation matrix corresponding to the optimal predicted distance matrix is determined as an optimal pose transformation matrix. Then, a predicted pose matrix corresponding to the optimal pose transformation matrix is determined as an optimal predicted pose matrix, and the optimal predicted pose matrix is determined as the corresponding pose matrix at the current moment.

Alternatively, FIG. 6 is a flowchart of a data compression method provided in the embodiment 1 of the present disclosure. As shown in FIG. 6, in step 203, transmitting the residual matrix and the distance matrix at the current moment to the decoding end after the residual matrix and the distance matrix at the current moment are encoded includes:
in step 601, dividing the distance matrix at the current moment using a versatile video coding (VVC) type coding division technology to obtain multiple sub-distance matrices;
in step 602, for each sub-distance matrix, judging whether spatial positions corresponding to non-zero elements in the sub-distance matrix and an optimal predicted distance matrix in a first 3D point cloud map are located on any first representative surface, performing coplanar coefficient encoding on the non-zero elements if the spatial positions corresponding to the non-zero elements are located on any first representative surface, and performing scatter encoding on the non-zero elements if the spatial positions corresponding to the non-zero elements are not located on any first representative surface, to obtain the encoded distance matrix at the current moment; and
in step 603, transmitting the encoded distance matrix at the current moment to the decoding end.

In combination with a scenario example, before the residual matrix and the distance matrix at the current moment are transmitted to the decoding end, it is necessary to first encode the residual matrix and the distance matrix at the current moment. Specifically, a VVC type coding division technology may be used to encode the distance matrix at the current moment. First, the distance matrix at the current moment is divided into 128x128 blocks, and then each 128x128 block is divided into a quadtree in turn. Then, blocks on leaf nodes are further divided into binary trees and ternary trees to obtain multiple small logical blocks; in other words, the distance matrix at the current moment is divided into multiple sub-distance matrices. Finally, all the divided small blocks within 128x128 are encoded in the Z scanning order, and the residual matrix is pose-encoded. Among them, before using the VVC type coding division technology to encode the small blocks divided from the distance matrix at the current moment, the non-zero elements for the distance value in each divided small block are first screened, and the positions corresponding to the non-zero elements are position-encoded. The position coding includes the coding of two parts of information, one is the number of the coding method, and the other is the encoding of the non-zero pixel position using the corresponding coding technology, which may use fixed-length encoding, run-length encoding, coordinate encoding, etc. And whether the spatial positions corresponding to the positions of the non-zero elements in the first 3D point cloud map and the spatial positions corresponding to the optimal prediction distance matrix are located on any first representative surface is determined. Among all non-zero elements, the non-zero elements whose corresponding spatial positions in the first 3D point cloud map are located on any first representative surface are coplanar coefficient-encoded, and the remaining non-zero elements are scatter-encoded. Each divided small block is encoded in sequence according to the coplanar coefficient encoding and scatter encoding methods to obtain the encoded distance matrix at the current moment. Finally, the encoded residual matrix and the encoded distance matrix at the current moment are respectively transmitted to the decoding end. According to the method provided in this example, the residual matrix and the distance matrix at the current moment may be encoded effectively and quickly, which greatly reduces the amount of transmitted data and thus improves transmission efficiency.

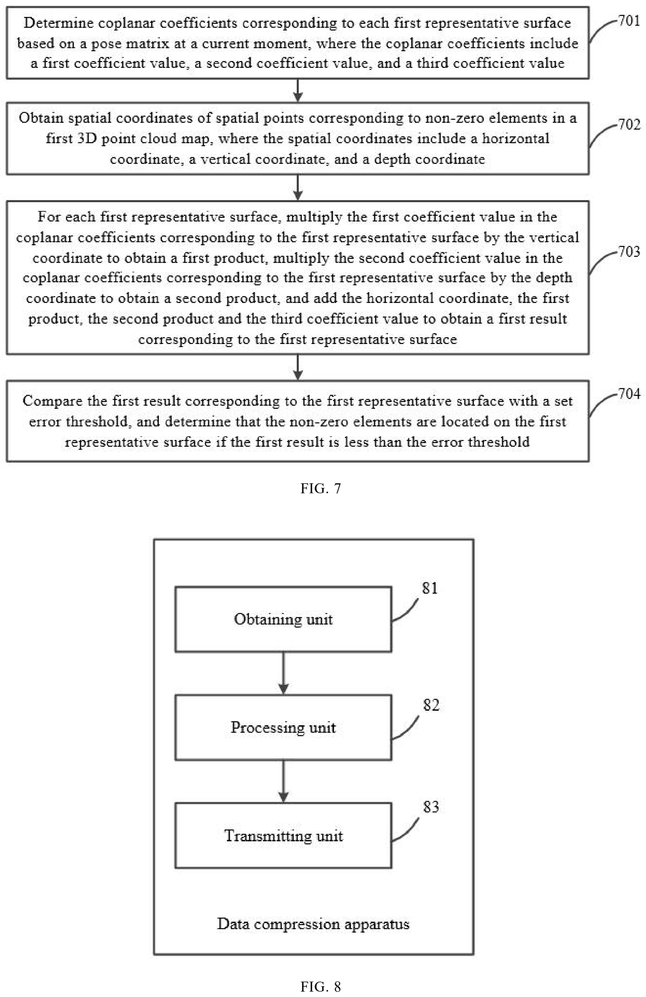

Alternatively, FIG. 7 is a flowchart of a data compression method provided in the embodiment 1 of the present disclosure. As shown in FIG. 7, in step 602, judging whether the spatial positions corresponding to the non-zero elements in the sub-distance matrix and the optimal predicted distance matrix in the first 3D point cloud map are located on any first representative surface includes:
in step 701, determining coplanar coefficients corresponding to each first representative surface based on the pose matrix at the current moment, where the coplanar coefficients include a first coefficient value, a second coefficient value, and a third coefficient value;
in step 702, obtaining spatial coordinates of spatial points corresponding to the non-zero elements in the first 3D point cloud map, where the spatial coordinates include a horizontal coordinate, a vertical coordinate, and a depth coordinate;
in step 703, for each first representative surface, multiplying the first coefficient value in the coplanar coefficients corresponding to the first representative surface by the vertical coordinate to obtain a first product, multiplying the second coefficient value in the coplanar coefficients corresponding to the first representative surface by the depth coordinate to obtain a second product, and adding the horizontal coordinate, the first product, the second product and the third coefficient value to obtain a first result corresponding to the first representative surface; and
in step 704, comparing the first result corresponding to the first representative surface with a set error threshold, and determining that the non-zero elements are located on the first representative surface if the first result is less than the error threshold.

In combination with a scenario example, for the spatial positions of the non-zero elements in the distance matrix at the current moment in the corresponding first 3D point cloud map, whether they are located on any first representative surface is judged. First, the coplanar coefficient of each first representative surface in the first 3D point cloud map may be determined through the pose matrix at the current moment. The coplanar coefficient includes a first coefficient value, a second coefficient value and a third coefficient value. For example, the position where the lidar scanner is located may be selected as the center of the circle, the driving direction of the vehicle as the positive direction of the horizontal axis, the positive direction of the horizontal axis as the reference, the direction rotated 90° counterclockwise as the positive direction of the vertical axis, and the upward direction perpendicular to the ground as the positive direction of the depth axis to establish a spatial rectangular coordinate system. In addition, when the spatial coordinates of each non-zero element in the distance matrix at the current moment in the corresponding first 3D point cloud map include the horizontal coordinate, the vertical coordinate and the depth coordinate. For each first representative surface, the first coefficient value in the coplanar coefficients corresponding to the first representative surface is multiplied by the vertical coordinate to obtain the first product, the second coefficient value in the coplanar coefficients corresponding to the first representative surface is multiplied by the depth coordinate to obtain the second product, and the horizontal coordinate, the first product, the second product and the third coefficient value are added to obtain the first result corresponding to the first representative surface. For example, if the first coefficient value, the second coefficient value, and the third coefficient value included in the coplanar coefficients of one of the first representative surfaces are a, b, and c respectively, and the horizontal coordinate, vertical coordinate, and depth coordinate of the non-zero element in the corresponding distance matrix at the current moment in the spatial coordinates of the corresponding first 3D point cloud map are x, y, and z respectively, the formula for computing the first result is: x+ay+bz-c. An error value is pre-set for the first result, and the error value may be ε. When the absolute value of the first result is not greater than the error value, it is determined that the spatial position of the computed non-zero element in the spatial coordinates of the first 3D point cloud map is located on the selected first representative surface.

Optionally, after the pose matrix at the current moment and the distance matrix at the current moment are obtained, the following is further included:
If the pose matrix at the previous moment does not exist in the historical pose matrices, the pose matrix at the current moment and the distance matrix at the current moment are encoded and then transmitted to the decoding end.

In combination with a scenario example, if the vehicle is running at the first moment of startup, the pose matrix at the previous moment may not exist at the decoding end, so there is no residual matrix at the first moment. Therefore, when transmitting to the decoding end, if the pose matrix at the previous moment does not exist at the decoding end, the pose matrix at the current moment and the distance matrix at the current moment will be transmitted to the decoding end after being encoded. If the pose matrix at the previous moment exists at the decoding end, the residual matrix at the current moment and the distance matrix at the current moment will be transmitted to the decoding end after being encoded.

According to the data compression method provided in the embodiment of the present disclosure, the pose matrix at the current moment and the distance matrix at the current moment are first obtained, where the pose matrix represents the rotation angle and position of the lidar scanner, and the distance matrix represents the distance value between the spatial point scanned by the lidar scanner and the lidar scanner; the pose matrix at the previous moment is retrieved from the historical pose matrices stored at the decoding end, and the difference value between the pose matrix at the current moment and the pose matrix at the previous moment is computed to obtain the residual matrix; the residual matrix and the distance matrix at the current moment are transmitted to the decoding end after being encoded, so that the decoding end obtains the pose matrix at the current moment based on the residual matrix and the pose matrix at the previous moment and stores the pose matrix at the current moment and the distance matrix at the current moment. Based on the method provided in this embodiment, the residual matrix of the lidar scanner in the autonomous driving system and the distance matrix between the surrounding environment and the lidar scanner are compressed and transmitted. Since the transmitted data is matrix data, the amount of transmitted data is greatly reduced, thereby improving the transmission efficiency.

### Embodiment 2

FIG. 8 is a schematic diagram of a structure of a data compression apparatus provided in the embodiment 2 of the present disclosure. As shown in FIG. 8, the apparatus includes:
an obtaining unit 81 configured to obtain a pose matrix at a current moment and a distance matrix at the current moment, where the pose matrix represents a rotation angle and position of a lidar scanner, and the distance matrix represents a distance value between a spatial point scanned by the lidar scanner and the lidar scanner;
a processing unit 82 configured to retrieve a pose matrix at a previous moment from historical pose matrices stored at a decoding end, and compute the difference value between the pose matrix at the current moment and the pose matrix at the previous moment to obtain a residual matrix; and
a transmitting unit 83 configured to transmit the residual matrix and the distance matrix at the current moment to the decoding end after encoding the residual matrix and the distance matrix at the current moment, so that the decoding end obtains the pose matrix at the current moment based on the residual matrix and the pose matrix at the previous moment and stores the pose matrix at the current moment and the distance matrix at the current moment.

The executor of this embodiment is a data compression apparatus, which may be implemented through a computer program, such as application software, etc.; or, it may also be implemented as a medium storing relevant computer programs, such as a USB flash drive, a cloud disk, etc.; or, it may also be implemented through a physical device integrated or installed with relevant computer programs, such as a chip, etc.

In combination with a scenario example, a vehicle using an autonomous driving system relies on a lidar scanner to obtain relevant data about the surrounding environment during operation. During the operation of the vehicle, the relative position of the vehicle and the ground is constantly changing, so the relative position between the lidar scanner and the ground is also constantly changing. Specifically, a pose matrix may be selected to represent the relative position between the lidar scanner and the ground and the rotation angle of the lidar scanner. The lidar scanner scans environmental information in the direction directly in front of the lidar scanner. Specifically, the environmental information in the direction directly in front of the lidar scanner may be recorded in the form of a distance matrix. The distance matrix includes the distance between each point of all objects in the space in the direction directly in front of the lidar scanner and the lidar scanner.

When a vehicle is driving, the speed and direction of the vehicle at the next moment is judged as follows: first, the obtaining unit 81 obtains the pose matrix and distance matrix of the lidar scanner at the current moment, and then the processing unit 82 retrieves the pose matrix of the lidar scanner at the previous moment from the decoding end. According to the pose matrices of the lidar scanner at the current moment and the previous moment, the residual matrix of the lidar scanner may be obtained. Specifically, the pose matrix of the lidar scanner at the current moment may be subtracted from the pose matrix of the lidar scanner at the previous moment to obtain the residual matrix of the lidar scanner. The residual matrix represents the changes of the lidar scanner, including changes in position and rotation angle. Then the transmitting unit 83 encodes and then transmits the residual matrix and distance matrix at the current moment to the decoding end, and the decoding end may obtain the residual matrix and distance matrix. The transmitting unit 83 adds the residual matrix to the pose matrix at the previous moment to obtain the pose matrix at the current moment, and stores the pose matrix and distance matrix of the lidar scanner at the current moment. At the same time, the transmitting unit 83 transmits the pose matrix and distance matrix of the lidar scanner at the current moment to the control end, so that the control end may make timely adjustments to the driving speed and direction of the vehicle according to the pose matrix and the distance matrix at the current moment.

According to the data compression apparatus provided by the embodiment of the present disclosure, first, the obtaining unit 81 obtains the pose matrix and distance matrix at the current moment, where the pose matrix represents the rotation angle and position of the lidar scanner, and the distance matrix represents the distance value between the spatial point scanned by the lidar scanner and the lidar scanner; the processing unit 82 retrieves the pose matrix at the previous moment from the historical pose matrices stored at the decoding end, and computes the difference value between the pose matrix at the current moment and the pose matrix at the previous moment to obtain the residual matrix; and the transmitting unit 83 transmits the residual matrix and the distance matrix at the current moment to the decoding end after encoding the residual matrix and the distance matrix at the current moment, so that the decoding end obtains the pose matrix at the current moment based on the residual matrix and the pose matrix at the previous moment and stores the pose matrix at the current moment and the distance matrix at the current moment. Based on the apparatus provided by the embodiment of the present disclosure, the residual matrix of the lidar scanner and the distance matrix between the surrounding environment and the lidar scanner in the autonomous driving system are compressed and transmitted. Since the transmitted data is matrix data, the amount of the transmitted data is greatly reduced, thereby improving the transmission efficiency.

Optionally, the obtaining unit 81 is specifically configured to retrieve the distance matrix at the previous moment and the pose matrix at the previous moment;
the obtaining unit 81 is specifically configured to, based on the distance matrix at the previous moment and the pose matrix at the previous moment, predict and obtain multiple sets of predicted pose matrices at the current moment, and obtain multiple sets of pose transformation matrices based on the multiple sets of predicted pose matrices and the pose matrix at the previous moment;
the obtaining unit 81 is specifically configured to obtain multiple sets of predicted distance matrices based on the distance matrix at the previous moment and internal parameters set by the lidar scanner; and
the obtaining unit 81 is specifically configured to compare the multiple sets of predicted distance matrices with the distance matrices at the current moment respectively to determine an optimal predicted distance matrix, and determine a pose transformation matrix corresponding to the optimal predicted distance matrix as an optimal pose transformation matrix, and determine a predicted pose matrix corresponding to the optimal pose transformation matrix as the pose matrix at the current moment.

In combination with a scenario example, when the vehicle is driving, the pose matrix of the lidar scanner may first make multiple sets of predictions based on the distance matrix at the previous moment and the pose matrix at the previous moment to obtain multiple sets of predicted pose matrices at the current moment. Each set of predicted pose matrices respectively represents the position and rotation angle that the lidar scanner may have at the current moment, and then the pose matrix at the previous moment is subtracted from the multiple sets of predicted pose matrices to obtain multiple sets of predicted pose transformation matrices. The obtaining unit 81 retrieves the distance matrix at the previous moment from the decoding end, and may obtain the internal parameters set by the lidar scanner at the previous moment based on the pose matrix at the previous moment. The internal parameters refer to the internal parameters of the lidar scanner. The spatial coordinates of the objects in the surrounding environment in the spatial coordinate system at the previous moment may be computed based on the internal parameters set by the lidar scanner and the distance matrix at the previous moment, and then the spatial coordinates of the objects in the surrounding environment in the spatial coordinate system at the previous moment are multiplied by the multiple sets of pose transformation matrices to obtain multiple sets of spatial coordinates of the objects in the surrounding environment in the spatial coordinate system at the current moment. Then, multiple sets of predicted distance matrices are obtained through the internal parameters set by the lidar scanner. The predicted distance matrix is a prediction of the distance matrix at the current moment, so the obtaining unit 81 obtains a predicted distance matrix with the most accurate prediction by comparing the distance matrix actually collected by the lidar scanner at the current moment with the predicted distance matrix, and the obtaining unit 81 determines the predicted distance matrix with the most accurate prediction as the optimal predicted distance matrix. Since there is a one-to-one correspondence between multiple sets of predicted distance matrices and multiple sets of predicted pose transformation matrices, the obtaining unit 81 may determine the optimal pose transformation matrix based on the optimal predicted distance matrix. Similarly, the predicted pose transformation matrix has a one-to-one correspondence with multiple sets of predicted pose matrices at the current moment, so the obtaining unit 81 may determine the optimal predicted pose matrix based on the optimal pose transformation matrix, and determine the optimal predicted pose matrix as the pose matrix at the current moment. The embodiment of the present disclosure predicts multiple sets of pose matrices at the current moment through the obtaining unit 81, obtains multiple sets of pose transformation matrices and multiple sets of predicted distance matrices, and determines the pose matrix at the current moment by selecting the optimal predicted distance matrix.

Optionally, the obtaining unit 81 is further configured to convert the multiple sets of predicted distance matrices into multiple sets of predicted 3D point cloud maps, and convert the distance matrix at the current moment into a first 3D point cloud map.

The obtaining unit 81 is further configured to compare the positions of the spatial points in the first 3D point cloud map with the positions of the spatial points in the multiple sets of predicted 3D point cloud maps, determine the predicted 3D point cloud map having the most identical spatial positions with the first 3D point cloud map as the optimal predicted 3D point cloud map, and determine the predicted distance matrix corresponding to the optimal predicted 3D point cloud map as the optimal predicted distance matrix.

In combination with a scenario example, after the multiple sets of predicted distance matrices are obtained, the obtaining unit 81 may obtain the multiple sets of predicted 3D point cloud maps by converting the distance values recorded in each set of predicted distance matrices into the corresponding 3D point cloud maps. At the same time, the obtaining unit 81 may convert the distance matrix at the current moment into the first 3D point cloud map. The information in the 3D point cloud map mainly includes the spatial position coordinates of each point scanned by the lidar scanner at the current moment. The obtaining unit 81 then compares the position coordinates represented in each set of predicted 3D point cloud maps with the position coordinates represented by the first 3D point cloud map, observes the number of identical position coordinates between each set of predicted 3D point cloud maps and the first 3D point cloud map, and determines the predicted 3D point cloud map that has the most identical position coordinates with the first 3D point cloud map as the optimal predicted 3D point cloud map. Then, the obtaining unit 81 determines the predicted distance matrix corresponding to the optimal predicted 3D point cloud map as the optimal predicted distance matrix, a pose transformation matrix corresponding to the optimal predicted distance matrix as an optimal pose transformation matrix, a predicted pose matrix corresponding to the optimal pose transformation matrix as an optimal predicted pose matrix, and the optimal predicted pose matrix as the corresponding pose matrix at the current moment.

Optionally, the obtaining unit 81 is further configured to determine multiple first representative surfaces based on the positions of the spatial points in the first 3D point cloud map, and for each predicted 3D point cloud map, determine a second representative surface corresponding to each first representative surface in the predicted 3D point cloud map based on the positions of the spatial points in the predicted 3D point cloud map, and compare the multiple first representative surfaces with the corresponding second representative surface in each predicted 3D point cloud map to see if they overlap.

The obtaining unit 81 is specifically further configured to determine the predicted 3D point cloud map that has the most overlapped representative surfaces with the first 3D point cloud map as the optimal predicted 3D point cloud map, and determine the predicted distance matrix corresponding to the optimal predicted 3D point cloud map as the optimal predicted distance matrix.

In combination with a scenario example, the obtaining unit 81 may determine the optimal predicted 3D point cloud map from the multiple sets of predicted 3D point cloud maps by observing the number of representative surfaces with the same direction between the multiple sets of predicted 3D point cloud maps and the first 3D point cloud map, and determine the predicted 3D point cloud map with the most representative surfaces with the same direction as the first 3D point cloud map as the optimal predicted 3D point cloud map. Specifically, the obtaining unit 81 first determines multiple first representative surfaces based on the spatial position coordinates of each point in the first 3D point cloud map, and then the obtaining unit 81 determines the second representative surface corresponding to each first representative surface on each set of predicted 3D point cloud maps, and determines the direction between each first representative surface and its corresponding second representative surface. If the directions are the same, it is determined that each first representative surface overlaps with its corresponding second representative surface. After comparing the representative surfaces of the first 3D point cloud map with those of each set of predicted 3D point cloud maps in turn, the obtaining unit 81 determines the predicted 3D point cloud map that has the most representative surfaces in the same direction as those of the first 3D point cloud map as the optimal predicted 3D point cloud map. Then the obtaining unit 81 determines the predicted distance matrix corresponding to the optimal predicted 3D point cloud map as the optimal predicted distance matrix, the pose transformation matrix corresponding to the optimal predicted distance matrix as the optimal pose transformation matrix, the predicted pose matrix corresponding to the optimal pose transformation matrix as the optimal predicted pose matrix, and the optimal predicted pose matrix as the pose matrix at the current moment.

Alternatively, the transmitting unit 83 is specifically configured to divide the distance matrix at the current moment by using a VVC type coding division technology to obtain multiple sub-distance matrices.

The transmitting unit 83 is further configured to, for each sub-distance matrix, determine whether the spatial positions corresponding to the non-zero elements in the sub-distance matrix and the optimal predicted distance matrix in the first 3D point cloud map are located on any first representative surface; if the spatial positions corresponding to the non-zero elements are located on any first representative surface, the non-zero elements are coplanar coefficient-encoded; if the spatial positions corresponding to the non-zero elements are not located on any first representative surface, the non-zero elements are scatter-encoded to obtain the encoded distance matrix at the current moment.

The transmitting unit 83 is further configured to transmit the encoded distance matrix at the current moment to the decoding end.

In combination with a scenario example, before the residual matrix and the distance matrix at the current moment are transmitted to the decoding end, it is necessary to first encode the residual matrix and the distance matrix at the current moment. Specifically, the transmitting unit 83 may choose to use the VVC type coding division technology to encode the distance matrix at the current moment. First, the distance matrix at the current moment is divided into 128x128, and then the transmitting unit 83 performs quadtree division on each 128x128 block in turn, and then continues to perform binary tree and ternary tree division on the blocks on the leaf nodes to obtain multiple small logical blocks; in other words, the distance matrix at the current moment is divided into multiple sub-distance matrices, and finally all the divided small blocks within 128x128 are encoded in the Z scanning order, and the residual matrix is pose-encoded. Among them, before using the VVC type coding division technology to encode the small blocks divided from the distance matrix at the current moment, the transmitting unit 83 first screens the non-zero elements for the distance values in each divided small block, and position encodes the positions corresponding to the non-zero elements. The position coding includes the encoding of two parts of information, one is the number of the coding method, and the other is the encoding of the non-zero pixel position using the corresponding coding technology, which may use fixed-length encoding, run-length encoding, coordinate encoding, etc. And the transmitting unit 83 determines whether the spatial positions corresponding to the positions of the non-zero elements in the first 3D point cloud map and the spatial positions corresponding to the optimal prediction distance matrix are located on any first representative surface. Among all non-zero elements, the transmitting unit 83 performs coplanar coefficient encoding on the non-zero elements whose corresponding spatial positions in the first 3D point cloud map are located on any first representative plane, and performs scatter encoding on the remaining non-zero elements. The transmitting unit 83 encodes each divided small block in sequence according to the coplanar coefficient encoding and scatter encoding method to obtain the encoded distance matrix at the current moment. Finally, the transmitting unit 83 transmits the encoded residual matrix and the encoded distance matrix at the current moment to the decoding end respectively. According to the method provided in this example, the residual matrix and the distance matrix at the current moment may be encoded effectively and quickly, which greatly reduces the amount of transmitted data and thus improves transmission efficiency.

Alternatively, the transmitting unit 83 is further configured to determine coplanar coefficients corresponding to each first representative surface based on the pose matrix at the current moment, where the coplanar coefficients include a first coefficient value, a second coefficient value, and a third coefficient value.

The transmitting unit 83 is further configured to obtain the spatial coordinates of the spatial point corresponding to the non-zero elements in the first 3D point cloud map, where the spatial coordinates include a horizontal coordinate, a vertical coordinate, and a depth coordinate.

The transmitting unit 83 is further configured to, for each first representative surface, multiply the first coefficient value in the coplanar coefficients corresponding to the first representative surface by the vertical coordinate to obtain a first product, multiply the second coefficient value in the coplanar coefficients corresponding to the first representative surface by the depth coordinate to obtain a second product, and add the horizontal coordinate, the first product, the second product, and the third coefficient value to obtain a first result corresponding to the first representative surface.

The transmitting unit 83 is further configured to compare the first result corresponding to the first representative surface with a set error threshold, and if the first result is less than the error threshold, it is determined that the non-zero elements are located on the first representative surface.

In combination with a scenario example, for the spatial positions of the non-zero elements in the distance matrix at the current moment in the corresponding first 3D point cloud map, whether they are located on any first representative surface is judged. The transmitting unit 83 may first determine the coplanar coefficients of each first representative surface in the first 3D point cloud map through the pose matrix at the current moment, and the coplanar coefficients include the first coefficient value, the second coefficient value and the third coefficient value. For example, the position where the lidar scanner is located may be selected as the center of the circle, the driving direction of the vehicle as the positive direction of the horizontal axis, the positive direction of the horizontal axis as the reference, the direction rotated 90° counterclockwise as the positive direction of the vertical axis, and the upward direction perpendicular to the ground as the positive direction of the depth axis to establish a spatial rectangular coordinate system. In addition, when the spatial coordinates of each non-zero element in the distance matrix at the current moment in the corresponding first 3D point cloud map include the horizontal coordinate, the vertical coordinate and the depth coordinate, for each first representative surface, the transmitting unit 83 multiplies the first coefficient value in the coplanar coefficients corresponding to the first representative surface by the vertical coordinate to obtain the first product, multiplies the second coefficient value in the coplanar coefficients corresponding to the first representative surface by the depth coordinate to obtain the second product, and adds the horizontal coordinate, the first product, the second product and the third coefficient value to obtain the first result corresponding to the first representative surface. For example, if the first coefficient value, the second coefficient value, and the third coefficient value included in the coplanar coefficients of one of the first representative surfaces are a, b, and c respectively, and the horizontal coordinate, the vertical coordinate, and the depth coordinate of the non-zero element in the distance matrix at the current moment in the spatial coordinates of the corresponding first 3D point cloud map are x, y, and z respectively, the formula for computing the first result is: x+ay+bz-c. An error value is pre-set for the first result, and the error value may be ε. When the absolute value of the first result is not greater than the error value, it is determined that the spatial position of the computed non-zero element in the spatial coordinates of the first 3D point cloud map is located on the selected first representative surface.

Optionally, the transmitting unit 83 is further configured to encode the pose matrix at the current moment and the distance matrix at the current moment and then transmit them to the decoding end if the pose matrix at the previous moment does not exist in the historical pose matrices.

In combination with a scenario example, if the vehicle is running at the first moment of startup, the pose matrix at the previous moment may not exist at the decoding end, so there is no residual matrix at the first moment. Therefore, when transmitting to the decoding end, if the pose matrix at the previous moment does not exist at the decoding end, the transmitting unit 83 will transmit the pose matrix at the current moment and the distance matrix at the current moment to the decoding end after encoding the pose matrix at the current moment and the distance matrix at the current moment. If the pose matrix at the previous moment exists at the decoding end, the transmitting unit 83 will transmit the residual matrix at the current moment and the distance matrix at the current moment to the decoding end after encoding the residual matrix at the current moment and the distance matrix at the current moment.

According to the data compression apparatus provided by the embodiment of the present disclosure, first, the obtaining unit obtains the pose matrix at the current moment and the distance matrix at the current moment, where the pose matrix represents the rotation angle and position of the lidar scanner, and the distance matrix represents the distance value between the spatial point scanned by the lidar scanner and the lidar scanner; the processing unit retrieves the pose matrix at the previous moment from the historical pose matrices stored at the decoding end, and computes the difference value between the pose matrix at the current moment and the pose matrix at the previous moment to obtain the residual matrix; the transmitting unit transmits the residual matrix and the distance matrix at the current moment to the decoding end after encoding the residual matrix and the distance matrix at the current moment, so that the decoding end obtains the pose matrix at the current moment based on the residual matrix and the pose matrix at the previous moment and stores the pose matrix at the current moment and the distance matrix at the current moment. Based on the apparatus provided in the embodiment of the present disclosure, the residual matrix of the lidar scanner in the autonomous driving system and the distance matrix between the surrounding environment and the lidar scanner are compressed and transmitted. Since the transmitted data is matrix data, the amount of transmitted data is greatly reduced, thereby improving transmission efficiency.

### Embodiment 3

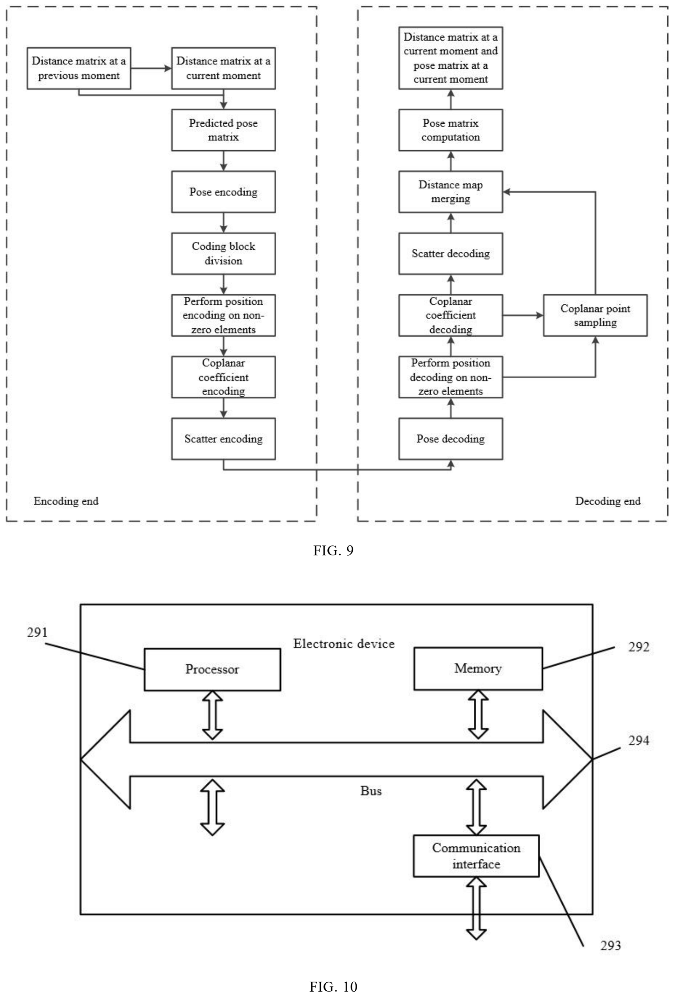

FIG. 9 is a flowchart of a data compression system provided in the embodiment 3 of the present disclosure. As shown in FIG. 9, the system includes: an encoding end and a decoding end. At the encoding end, a pose matrix at a current moment is first predicted based on a previous moment and a pose matrix at a previous moment to obtain multiple sets of predicted pose matrices and then determine an optimal predicted pose matrix, the optimal predicted pose matrix is determined as the pose matrix at the current moment, the residual matrix is obtained by subtracting the pose matrix at the current moment from the pose matrix at the previous moment, and the residual matrix is pose-encoded. A distance matrix at a current moment is divided into multiple coding blocks through a VVC type coding division technology, and non-zero elements in each coding block are screened, and a position of each non-zero element in a first 3D point cloud map is position-encoded, and whether each non-zero element is located on any representative surface in the first 3D point cloud map is judged, and non-zero elements located on any representative surface in the first 3D point cloud map are coplanar coefficient-encoded, and non-zero elements not located on any representative surface in the first 3D point cloud map are scatter-encoded, and then the content after position encoding, coplanar coefficient encoding and scatter encoding is transmitted to the decoding end. The decoding end then performs position decoding on the content after position encoding, coplanar coefficient encoding and scatter encoding. The residual matrix and the distance matrix at the current moment are obtained through the coplanar coefficient decoding and the scatter decoding. The pose matrix at the current moment is obtained based on the residual matrix and the pose matrix at the previous moment. Based on the apparatus provided in the embodiment of the present disclosure, the residual matrix of the lidar scanner in the autonomous driving system and the distance matrix between the surrounding environment and the lidar scanner are compressed and transmitted. Since the transmitted data is matrix data, the amount of transmitted data is greatly reduced, thereby improving transmission efficiency.

### Embodiment 4

FIG. 10 is a schematic diagram of a structure of an electronic device provided in the embodiment 4 of the present disclosure. As shown in FIG. 10, the electronic device may include:
a processor 291. The electronic device may further include a memory 292. The electronic device may further include a communication interface 293 and a bus 294. The processor 291, the memory 292, the communication interface 293 may communicate with each other through the bus 294. The communication interface 293 may be configured for information transmission. The processor 291 may call logic instructions in the memory 292 to execute the method of the above-mentioned embodiment 1.

In addition, the logic instructions in the memory 292 may be implemented in the form of software functional units and may be stored in a computer-readable storage medium when sold or used as an independent product.

The memory 292, as a computer-readable storage medium, may be used to store software programs, computer-executable programs, such as program instructions/units corresponding to the method in the embodiments of the present disclosure. The processor 291 executes the software programs, instructions, and units stored in the memory 292 to perform functional applications and data processing, that is, to implement the method of the above-mentioned embodiment 1.

The memory 292 may include a program storage area and a data storage area, where the program storage area may store an operating system and application programs required for at least one function, and the data storage area may store data created according to the use of the terminal device, etc. In addition, the memory 292 may include a high-speed random access memory and may also include a non-volatile memory.

The embodiment of the present disclosure provides a non-transitory computer-readable storage medium, where the computer-readable storage medium stores computer execution instructions, which, when executed by a processor, are used to implement the method described in the above embodiment.

Other embodiments of the disclosure will be apparent to those skilled in the art from consideration of the specification and practice of the invention claimed herein. The present disclosure is intended to cover any modifications, uses or adaptations of the present disclosure that follow the general principles of the present disclosure and include common knowledge or customary technical means in the technical field not covered by the present disclosure. It is intended that the specification and examples be considered as exemplary only, with a true scope and spirit of the disclosure being indicated by the following claims.

The foregoing may be better understood according to the following articles.

Article A1. A data compression method, including:
obtaining a pose matrix at a current moment and a distance matrix at the current moment, where the pose matrix represents a rotation angle and position of a lidar scanner, and the distance matrix represents a distance value between a spatial point scanned by the lidar scanner and the lidar scanner;
retrieving a pose matrix at a previous moment from historical pose matrices stored at a decoding end, and computing a difference value between the pose matrix at the current moment and the pose matrix at the previous moment to obtain a residual matrix; and
transmitting the residual matrix and the distance matrix at the current moment to the decoding end after encoding the residual matrix and the distance matrix at the current moment, so that the decoding end obtains the pose matrix at the current moment based on the residual matrix and the pose matrix at the previous moment and stores the pose matrix at the current moment and the distance matrix at the current moment.

Article A2. The method of article A1, where obtaining the pose matrix at the current moment includes:
retrieving a distance matrix at the previous moment and the pose matrix at the previous moment;
predicting and obtaining multiple sets of predicted pose matrices at the current moment based on the distance matrix at the previous moment and the pose matrix at the previous moment, and obtaining multiple sets of pose transformation matrices based on the multiple sets of predicted pose matrices and the pose matrix at the previous moment;
obtaining multiple sets of predicted distance matrices based on the distance matrix at the previous moment and internal parameters set by the lidar scanner; and
comparing the multiple sets of predicted distance matrices with the distance matrix at the current moment respectively to determine an optimal predicted distance matrix, determining a pose transformation matrix corresponding to the optimal predicted distance matrix as an optimal pose transformation matrix, and determining a predicted pose matrix corresponding to the optimal pose transformation matrix as the pose matrix at the current moment.

Article A3. The method of article A2, where comparing the multiple sets of predicted distance matrices with the distance matrix at the current moment respectively to determine the optimal predicted distance matrix includes:
converting the multiple sets of predicted distance matrices into multiple sets of predicted 3D point cloud maps respectively, and converting the distance matrix at the current moment into a first 3D point cloud map; and
comparing positions of spatial points in the first 3D point cloud map with positions of spatial points in the multiple sets of predicted 3D point cloud maps, determining a predicted 3D point cloud map that has the most identical spatial positions with the first 3D point cloud map as an optimal predicted 3D point cloud map, and determining a predicted distance matrix corresponding to the optimal predicted 3D point cloud map as the optimal predicted distance matrix.

Article A4. The method of article A3, further including:
determining multiple first representative surfaces based on the positions of the spatial points in the first 3D point cloud map, and for each predicted 3D point cloud map, determining a second representative surface corresponding to each first representative surface in the predicted 3D point cloud map based on positions of spatial points in the predicted 3D point cloud map, and comparing the multiple first representative surfaces with the corresponding second representative surface in each predicted 3D point cloud map to see if they overlap; and
determining a predicted 3D point cloud map that has the most overlapped representative surfaces with the first 3D point cloud map as the optimal predicted 3D point cloud map, and determining the predicted distance matrix corresponding to the optimal predicted 3D point cloud map as the optimal predicted distance matrix.

Article A5. The method of article A1, where transmitting the residual matrix and the distance matrix at the current moment to the decoding end after encoding the residual matrix and the distance matrix at the current moment to the decoding end includes:
dividing the distance matrix at the current moment using a versatile video coding (VVC) type coding division technology to obtain multiple sub-distance matrices;
for each sub-distance matrix, judging whether spatial positions corresponding to non-zero elements in the sub-distance matrix and an optimal predicted distance matrix in a first 3D point cloud map are located on any first representative surface, performing coplanar coefficient encoding on the non-zero elements if the spatial positions corresponding to the non-zero elements are located on any first representative surface, and performing scatter encoding on the non-zero elements if the spatial positions corresponding to the non-zero elements are not located on any first representative surface, so as to obtain the encoded distance matrix at the current moment; and
transmitting the encoded distance matrix at the current moment to the decoding end.

Article A6. The method of article A5, where judging whether the spatial positions corresponding to the non-zero elements in the sub-distance matrix and the optimal predicted distance matrix in the first 3D point cloud map are located on any first representative surface includes:
determining coplanar coefficients corresponding to each first representative surface based on the pose matrix at the current moment, where the coplanar coefficients include a first coefficient value, a second coefficient value, and a third coefficient value;
obtaining spatial coordinates of spatial points corresponding to the non-zero elements in the first 3D point cloud map, where the spatial coordinates include a horizontal coordinate, a vertical coordinate, and a depth coordinate;
for each first representative surface, multiplying the first coefficient value in the coplanar coefficients corresponding to the first representative surface by the vertical coordinate to obtain a first product, multiplying the second coefficient value in the coplanar coefficients corresponding to the first representative surface by the depth coordinate to obtain a second product, and adding the horizontal coordinate, the first product, the second product and the third coefficient value to obtain a first result corresponding to the first representative surface; and
comparing the first result corresponding to the first representative surface with a set error threshold, and determining that the non-zero elements are located on the first representative surface if the first result is less than the error threshold.

Article A7. The method of any one of articles A1-A6, where after the pose matrix at the current moment and the distance matrix at the current moment are obtained, the method further includes:
transmitting the pose matrix at the current moment and the distance matrix at the current moment to the decoding end after the pose matrix at the current moment and the distance matrix at the current moment are encoded if the pose matrix at the previous moment does not exist in the historical pose matrices.

Article B1. A data compression apparatus, including:
an obtaining unit configured to obtain a pose matrix at a current moment and a distance matrix at the current moment, where the pose matrix represents a rotation angle and position of a lidar scanner, and the distance matrix represents a distance value between a spatial point scanned by the lidar scanner and the lidar scanner;
a processing unit configured to retrieve a pose matrix at a previous moment from historical pose matrices stored at a decoding end and compute a difference value between the pose matrix at the current moment and the pose matrix at the previous moment to obtain a residual matrix; and
a transmitting unit configured to transmit the residual matrix and the distance matrix at the current moment to the decoding end after encoding the residual matrix and the distance matrix at the current moment, so that the decoding end obtains the pose matrix at the current moment based on the residual matrix and the pose matrix at the previous moment and stores the pose matrix at the current moment and the distance matrix at the current moment.

Article B2. The apparatus of article B1, where
the obtaining unit is specifically configured to retrieve a distance matrix at the previous moment and the pose matrix at the previous moment;
the obtaining unit is specifically configured to predict and obtain multiple sets of predicted pose matrices at the current moment based on the distance matrix at the previous moment and the pose matrix at the previous moment and obtain multiple sets of pose transformation matrices based on the multiple sets of predicted pose matrices and the pose matrix at the previous moment;
the obtaining unit is specifically configured to obtain multiple sets of predicted distance matrices based on the distance matrix at the previous moment and internal parameters set by the lidar scanner; and
the obtaining unit is specifically configured to compare the multiple sets of predicted distance matrices with the distance matrix at the current moment respectively to determine an optimal predicted distance matrix, determine a pose transformation matrix corresponding to the optimal predicted distance matrix as an optimal pose transformation matrix, and determine a predicted pose matrix corresponding to the optimal pose transformation matrix as the pose matrix at the current moment.

Article B3. The apparatus of article B2, where
the obtaining unit is specifically configured to convert the multiple sets of predicted distance matrices into multiple sets of predicted 3D point cloud maps and convert the distance matrix at the current moment into a first 3D point cloud map; and
the obtaining unit is specifically configured to compare positions of spatial points in the first 3D point cloud map with positions of spatial points in the multiple sets of predicted 3D point cloud maps respectively, determine a predicted 3D point cloud map that has the most identical spatial positions with the first 3D point cloud map as an optimal predicted 3D point cloud map, and determine a predicted distance matrix corresponding to the optimal predicted 3D point cloud map as the optimal predicted distance matrix.

Article B4. The apparatus of article B3, where
the obtaining unit is specifically configured to determine multiple first representative surfaces based on the positions of the spatial points in the first 3D point cloud map, and for each predicted 3D point cloud map, determine a second representative surface corresponding to each first representative surface in the predicted 3D point cloud map based on positions of spatial points in the predicted 3D point cloud map, and compare the multiple first representative surfaces with the corresponding second representative surface in each predicted 3D point cloud map to see if they overlap; and
the obtaining unit is specifically configured to determine a predicted 3D point cloud map that has the most overlapped representative surfaces with the first 3D point cloud map as the optimal predicted 3D point cloud map, and determine the predicted distance matrix corresponding to the optimal predicted 3D point cloud map as the optimal predicted distance matrix.

Article B5. The apparatus of article B1, where
the transmitting unit is specifically configured to divide the distance matrix at the current moment using a versatile video coding (VVC) type coding division technology to obtain multiple sub-distance matrices;
the transmitting unit is specifically configured to, for each sub-distance matrix, judge whether spatial positions corresponding to non-zero elements in the sub-distance matrix and an optimal predicted distance matrix in a first 3D point cloud map are located on any first representative surface, perform coplanar coefficient encoding on the non-zero elements if the spatial positions corresponding to the non-zero elements are located on any first representative surface, and perform scatter encoding on the non-zero elements if the spatial positions corresponding to the non-zero elements are not located on any first representative surface, so as to obtain the encoded distance matrix at the current moment; and
the transmitting unit is specifically configured to transmit the encoded distance matrix at the current moment to the decoding end.

Article B6. The apparatus of article B5, where
the transmitting unit is specifically configured to determine coplanar coefficients corresponding to each first representative surface based on the pose matrix at the current moment, where the coplanar coefficients include a first coefficient value, a second coefficient value, and a third coefficient value;
the transmitting unit is specifically configured to obtain spatial coordinates of spatial points corresponding to the non-zero elements in the first 3D point cloud map, where the spatial coordinates include a horizontal coordinate, a vertical coordinate, and a depth coordinate;
the transmitting unit is specifically configured to, for each first representative surface, multiply the first coefficient value in the coplanar coefficients corresponding to the first representative surface by the vertical coordinate to obtain a first product, multiply the second coefficient value in the coplanar coefficients corresponding to the first representative surface by the depth coordinate to obtain a second product, and add the horizontal coordinate, the first product, the second product and the third coefficient value to obtain a first result corresponding to the first representative surface; and
the transmitting unit is specifically configured to compare the first result corresponding to the first representative surface with a set error threshold, and determine that the non-zero elements are located on the first representative surface if the first result is less than the error threshold.

Article B7. The apparatus of any one of articles B1-B6, where
the transmitting unit is specifically configured to transmit the pose matrix at the current moment and the distance matrix at the current moment to the decoding end after the pose matrix at the current moment and the distance matrix at the current moment are encoded if the pose matrix at the previous moment does not exist in the historical pose matrices.

Article C1. An electronic device, including: a processor; and a memory communicatively connected to the processor, where
the memory stores computer execution instructions; and
the processor executes the computer execution instructions stored by the memory to implement the method as described in any of the above.

Article D1. A computer-readable storage medium, on which computer execution instructions are stored, which, when executed by a processor, are used to implement the method as described in any of the above.

It should be understood that this application is not limited to the precise structure already described above and shown in the attached drawings, and that various modifications and changes may be made without deviating from the scope of this application. The scope of this application is limited only by the attached claims.

## Claims

1. A data compression method, comprising:
obtaining a pose matrix at a current moment and a distance matrix at the current moment, wherein the pose matrix represents a rotation angle and position of a lidar scanner, and the distance matrix represents a distance value between a spatial point scanned by the lidar scanner and the lidar scanner;
retrieving a pose matrix at a previous moment from historical pose matrices stored at a decoding end, and computing a difference value between the pose matrix at the current moment and the pose matrix at the previous moment to obtain a residual matrix; and
transmitting the residual matrix and the distance matrix at the current moment to the decoding end after encoding the residual matrix and the distance matrix at the current moment, so that the decoding end obtains the pose matrix at the current moment based on the residual matrix and the pose matrix at the previous moment and stores the pose matrix at the current moment and the distance matrix at the current moment.

2. The method of claim 1, wherein obtaining the pose matrix at the current moment comprises:
retrieving a distance matrix at the previous moment and the pose matrix at the previous moment;
predicting and obtaining multiple sets of predicted pose matrices at the current moment based on the distance matrix at the previous moment and the pose matrix at the previous moment, and obtaining multiple sets of pose transformation matrices based on the multiple sets of predicted pose matrices and the pose matrix at the previous moment;
obtaining multiple sets of predicted distance matrices based on the distance matrix at the previous moment and internal parameters set by the lidar scanner; and
comparing the multiple sets of predicted distance matrices with the distance matrix at the current moment respectively to determine an optimal predicted distance matrix, determining a pose transformation matrix corresponding to the optimal predicted distance matrix as an optimal pose transformation matrix, and determining a predicted pose matrix corresponding to the optimal pose transformation matrix as the pose matrix at the current moment.

3. The method of claim 2, wherein comparing the multiple sets of predicted distance matrices with the distance matrix at the current moment respectively to determine the optimal predicted distance matrix comprises:
converting the multiple sets of predicted distance matrices into multiple sets of predicted 3D point cloud maps respectively, and converting the distance matrix at the current moment into a first 3D point cloud map; and
comparing positions of spatial points in the first 3D point cloud map with positions of spatial points in the multiple sets of predicted 3D point cloud maps, determining a predicted 3D point cloud map that has the most identical spatial positions with the first 3D point cloud map as an optimal predicted 3D point cloud map, and determining a predicted distance matrix corresponding to the optimal predicted 3D point cloud map as the optimal predicted distance matrix.

4. The method of claim 3, further comprising:
determining multiple first representative surfaces based on the positions of the spatial points in the first 3D point cloud map, and for each predicted 3D point cloud map, determining a second representative surface corresponding to each first representative surface in the predicted 3D point cloud map based on positions of spatial points in the predicted 3D point cloud map, and comparing the multiple first representative surfaces with the corresponding second representative surface in each predicted 3D point cloud map to see if they overlap; and
determining a predicted 3D point cloud map that has the most overlapped representative surfaces with the first 3D point cloud map as the optimal predicted 3D point cloud map, and determining the predicted distance matrix corresponding to the optimal predicted 3D point cloud map as the optimal predicted distance matrix.

5. The method of claim 1, wherein transmitting the residual matrix and the distance matrix at the current moment to the decoding end after encoding the residual matrix and the distance matrix at the current moment comprises:
dividing the distance matrix at the current moment using a versatile video coding (VVC) type coding division technology to obtain multiple sub-distance matrices;
for each sub-distance matrix, judging whether spatial positions corresponding to non-zero elements in the sub-distance matrix and an optimal predicted distance matrix in a first 3D point cloud map are located on any first representative surface, performing coplanar coefficient encoding on the non-zero elements if the spatial positions corresponding to the non-zero elements are located on any first representative surface, and performing scatter encoding on the non-zero elements if the spatial positions corresponding to the non-zero elements are not located on any first representative surface, so as to obtain the encoded distance matrix at the current moment; and
transmitting the encoded distance matrix at the current moment to the decoding end.

6. The method of claim 5, wherein judging whether the spatial positions corresponding to the non-zero elements in the sub-distance matrix and the optimal predicted distance matrix in the first 3D point cloud map are located on any first representative surface comprises:
determining coplanar coefficients corresponding to each first representative surface based on the pose matrix at the current moment, wherein the coplanar coefficients comprise a first coefficient value, a second coefficient value, and a third coefficient value;
obtaining spatial coordinates of spatial points corresponding to the non-zero elements in the first 3D point cloud map, wherein the spatial coordinates comprise a horizontal coordinate, a vertical coordinate, and a depth coordinate;
for each first representative surface, multiplying the first coefficient value in the coplanar coefficients corresponding to the first representative surface by the vertical coordinate to obtain a first product, multiplying the second coefficient value in the coplanar coefficients corresponding to the first representative surface by the depth coordinate to obtain a second product, and adding the horizontal coordinate, the first product, the second product and the third coefficient value to obtain a first result corresponding to the first representative surface; and
comparing the first result corresponding to the first representative surface with a set error threshold, and determining that the non-zero elements are located on the first representative surface if the first result is less than the error threshold.

7. The method of any one of claims 1-6, wherein after the pose matrix at the current moment and the distance matrix at the current moment are obtained, the method further comprises:
transmitting the pose matrix at the current moment and the distance matrix at the current moment to the decoding end after the pose matrix at the current moment and the distance matrix at the current moment are encoded if the pose matrix at the previous moment does not exist in the historical pose matrices.

8. A data compression apparatus, comprising:
an obtaining unit configured to obtain a pose matrix at a current moment and a distance matrix at the current moment, wherein the pose matrix represents a rotation angle and position of a lidar scanner, and the distance matrix represents a distance value between a spatial point scanned by the lidar scanner and the lidar scanner;
a processing unit configured to retrieve a pose matrix at a previous moment from historical pose matrices stored at a decoding end and compute a difference value between the pose matrix at the current moment and the pose matrix at the previous moment to obtain a residual matrix; and
a transmitting unit configured to transmit the residual matrix and the distance matrix at the current moment to the decoding end after encoding the residual matrix and the distance matrix at the current moment, so that the decoding end obtains the pose matrix at the current moment based on the residual matrix and the pose matrix at the previous moment and stores the pose matrix at the current moment and the distance matrix at the current moment.

9. The apparatus of claim 8, wherein
the obtaining unit is specifically configured to retrieve a distance matrix at the previous moment and the pose matrix at the previous moment;
the obtaining unit is specifically configured to predict and obtain multiple sets of predicted pose matrices at the current moment based on the distance matrix at the previous moment and the pose matrix at the previous moment and obtain multiple sets of pose transformation matrices based on the multiple sets of predicted pose matrices and the pose matrix at the previous moment;
the obtaining unit is specifically configured to obtain multiple sets of predicted distance matrices based on the distance matrix at the previous moment and internal parameters set by the lidar scanner; and
the obtaining unit is specifically configured to compare the multiple sets of predicted distance matrices with the distance matrix at the current moment respectively to determine an optimal predicted distance matrix, determine a pose transformation matrix corresponding to the optimal predicted distance matrix as an optimal pose transformation matrix, and determine a predicted pose matrix corresponding to the optimal pose transformation matrix as the pose matrix at the current moment.

10. The apparatus of claim 9, wherein
the obtaining unit is specifically configured to convert the multiple sets of predicted distance matrices into multiple sets of predicted 3D point cloud maps respectively, and convert the distance matrix at the current moment into a first 3D point cloud map; and
the obtaining unit is specifically configured to compare positions of spatial points in the first 3D point cloud map with positions of spatial points in the multiple sets of predicted 3D point cloud maps, determine a predicted 3D point cloud map that has the most identical spatial positions with the first 3D point cloud map as an optimal predicted 3D point cloud map, and determine a predicted distance matrix corresponding to the optimal predicted 3D point cloud map as the optimal predicted distance matrix.

11. The apparatus of claim 10, wherein
the obtaining unit is specifically configured to determine multiple first representative surfaces based on the positions of the spatial points in the first 3D point cloud map, and for each predicted 3D point cloud map, determine a second representative surface corresponding to each first representative surface in the predicted 3D point cloud map based on positions of spatial points in the predicted 3D point cloud map, and compare the multiple first representative surfaces with the corresponding second representative surface in each predicted 3D point cloud map to see if they overlap; and
the obtaining unit is specifically configured to determine a predicted 3D point cloud map that has the most overlapped representative surfaces with the first 3D point cloud map as the optimal predicted 3D point cloud map, and determine the predicted distance matrix corresponding to the optimal predicted 3D point cloud map as the optimal predicted distance matrix.

12. The apparatus of claim 8, wherein
the transmitting unit is specifically configured to divide the distance matrix at the current moment using a versatile video coding (VVC) type coding division technology to obtain multiple sub-distance matrices;
the transmitting unit is specifically configured to, for each sub-distance matrix, judge whether spatial positions corresponding to non-zero elements in the sub-distance matrix and an optimal predicted distance matrix in a first 3D point cloud map are located on any first representative surface, perform coplanar coefficient encoding on the non-zero elements if the spatial positions corresponding to the non-zero elements are located on any first representative surface, and perform scatter encoding on the non-zero elements if the spatial positions corresponding to the non-zero elements are not located on any first representative surface, so as to obtain the encoded distance matrix at the current moment; and
the transmitting unit is specifically configured to transmit the encoded distance matrix at the current moment to the decoding end.

13. The apparatus of claim 12, wherein
the transmitting unit is specifically configured to determine coplanar coefficients corresponding to each first representative surface based on the pose matrix at the current moment, wherein the coplanar coefficients comprise a first coefficient value, a second coefficient value, and a third coefficient value;
the transmitting unit is specifically configured to obtain spatial coordinates of spatial points corresponding to the non-zero elements in the first 3D point cloud map, wherein the spatial coordinates comprise a horizontal coordinate, a vertical coordinate, and a depth coordinate;
the transmitting unit is specifically configured to, for each first representative surface, multiply the first coefficient value in the coplanar coefficients corresponding to the first representative surface by the vertical coordinate to obtain a first product, multiply the second coefficient value in the coplanar coefficients corresponding to the first representative surface by the depth coordinate to obtain a second product, and add the horizontal coordinate, the first product, the second product and the third coefficient value to obtain a first result corresponding to the first representative surface; and
the transmitting unit is specifically configured to compare the first result corresponding to the first representative surface with a set error threshold, and determine that the non-zero elements are located on the first representative surface if the first result is less than the error threshold.

14. The apparatus of any one of claims 8-13, wherein
the transmitting unit is specifically configured to transmit the pose matrix at the current moment and the distance matrix at the current moment to the decoding end after the pose matrix at the current moment and the distance matrix at the current moment are encoded if the pose matrix at the previous moment does not exist in the historical pose matrices.

15. An electronic device, comprising: a processor; and a memory communicatively connected to the processor, wherein
the memory stores computer execution instructions; and
the processor executes the computer execution instructions stored by the memory to implement the method of any one of claims 1-7.

16. A computer-readable storage medium, on which computer execution instructions are stored, which, when executed by a processor, are used to implement the method of any one of claims 1-7.
